# EUROPEAN PATENT APPLICATION

(11) **EP 2 506 332 A1**
(43) Date of publication of application: **03.10.2012**
(21) Application number: 12153895.3
(22) Date of filing: 03.02.2012
(51) Int. Cl.: H01L 51/52

(54) **Substrate for improved handling and protection of an optoelectronic device**

(30) Priority: 31.03.2011 IN EL09092011 D
(71) Applicant: Moser Baer India Ltd., New Dehli 110020 (IN)
(72) Inventor: Marsman, Herman G., 110020 New Dehli (IN)
(74) Representative: Beck & Rössig European Patent Attorneys

(57) **Abstract**

A substrate (100) having a base layer (102, 302) and a secondary layer (110, 310) for use in an optoelectronic device (300a, 300b) is provided. The base layer (102, 302) of the substrate (100) includes a first surface (104, 304) and a second surface (106, 306). The first surface (104, 304) is configured to have one or more device components (316 - 328) of the optoelectronic device (300a, 300b) to be deposited thereon and the second surface (106, 306) supports a texture (108, 308) thereon to facilitate light management in the optoelectronic device (300a, 300b). The secondary layer (110, 310) of the substrate (100) is disposed over the texture (108, 308), such that a top surface (114, 314) of the secondary layer (110, 310) is substantially flat and acts as an interface between the optoelectronic device (300a, 300b) and an ambient medium. Also, the secondary (110, 310) layer of the substrate (100) enables at least one of protection of the texture (108, 308) from the ambient medium and vacuum-based handling of the substrate (100).

## Description

### FIELD OF INVENTION

The invention disclosed herein relates, in general, to semiconductor devices. More specifically, the present invention relates to an improved substrate for use in the semiconductor devices.

### BACKGROUND

Semiconductor materials are commonly used as electroluminescent materials in optoelectronic devices like Organic Light Emitting Diodes (OLEDs) and as photovoltaic materials in Thin Film Photovoltaic Devices (TF-PVs).

In OLEDs for example, when a voltage is applied across layers of the semiconductor materials, electrons and holes are injected from their respective electrodes. The electrons and holes recombine in the layers of the semiconductor materials and form excitons, thereby emitting light. Therefore, in functioning of optoelectronic devices like the OLEDs, light management is a very critical aspect that substantially affects the efficiency of such devices.

In an OLED the light emitted by the layers of the semiconductor materials needs to pass through a substrate of the OLEDs to be emitted. However, when light is incident from a high refractive index material onto an interface with a lower refractive index material or medium, the light undergoes total internal reflection (TIR). Generally, a refractive index of the layers of the semiconductor materials is greater than a refractive index of the substrate in the OLEDs. In the OLEDs, due to this difference in the refractive indices, emitted light gets reflected back from the substrate, through the layers of semiconductor materials, thereby reducing the percentage of the emitted light that can be extracted. Similarly, due to a difference in the refractive indices of the substrate and an ambient medium in which the OLEDs are used, some of the emitted light gets reflected back into the substrate at the interface between the substrate and the ambient medium. This further decreases the efficiency of the OLEDs.

This is usually prevented by providing a light extraction texture at interfaces where the TIR can occur. The light extraction texture is capable of changing the propagation direction of the light emitted and help in reducing the TIR back into the OLED. For example, an external light extraction texture provided at the interface between the substrate and the ambient medium helps in reducing any TIR at that interface.

However, presence of the external light extraction texture at the interface between the substrate and the ambient medium creates problems during manufacturing of the OLED. For example, during various stages of the manufacturing process, the substrate having the external light extraction texture needs to be picked up or moved or rotated using mechanical devices. These movements often result in deformation of the external light extraction texture. Also, the mechanical devices, for example, vacuum grippers, used for enabling these movements find it difficult to handle the substrates having the external light extraction texture.

In light of the above discussion, there is therefore a need for substrates that allow easy handling while manufacturing of the optoelectronic devices and at the same time provide efficient light extraction, thereby eliminating one or more drawbacks of the prior art.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1a illustrates a base layer and a secondary layer of an exemplary substrate for use in an optoelectronic device separately, in accordance with an embodiment of the present invention;
FIG. 1b illustrates the exemplary substrate of FIG. 1a, such that the secondary layer is disposed on the base layer, in accordance with an embodiment of the present invention;
FIGs. 2a, 2b and 2c illustrate a graphical representation of experimental simulations carried out with various substrates in accordance with an embodiment of the present invention;
FIG. 3 illustrates a stack of layers in an exemplary optoelectronic device, in accordance with an embodiment of the present invention;
FIG. 4 is a flow chart describing an exemplary process of forming an exemplary optoelectronic device, in accordance with an embodiment of the present invention;
FIGs. 5a and 5b show examples of vacuum grippers.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### SUMMARY

The present invention provides a substrate for use in an optoelectronic device for example an Organic Light Emitting Diode (OLED). The substrate has a base layer, one side of which has the stack of layers of the OLED and the other side has a texture to facilitate light extraction. A secondary layer is deposited on the texture to protect it during handling and manufacturing processes and also provide a flat surface for mechanical handling devices, like, vacuum gripper for easy gripping. For example, if there was no secondary layer, then the vacuum grippers would be gripping the OLED from the textured surface, which would not provide sufficient vacuum due to the presence of the texture and corresponding gaps within the texture which do not let the vacuum develop properly.

In some embodiments, the present invention provides a substrate having a base layer and a secondary layer for use in an optoelectronic device. The base layer of the substrate includes a first surface and a second surface. The first surface is configured to have one or more device components of the optoelectronic device to be deposited thereon and the second surface supports a texture thereon to facilitate light management in the optoelectronic device. Further, the secondary layer of the substrate is disposed over the texture such that a top surface of the secondary layer is substantially flat, whereby an interface between the optoelectronic device and an ambient medium is also substantially flat. Also, the secondary layer of the substrate enables at least one of protection of the texture from the ambient medium and vacuum-based handling of the substrate.

In some embodiments the texture is directly imprinted on the second surface of said substrate.

In some embodiments, the texture is formed on a lacquer layer deposited on the second surface of the substrate.

In some embodiments, the light management facilitated by the texture is light extraction when the optoelectronic device is one of an Organic Light Emitting Diode (OLED) and a Light Emitting Diode (LED).

In some embodiments, the light management facilitated by the texture is light trapping when the optoelectronic device is a Thin Film Photovoltaic Device (TF-PV).

In some embodiments, a material of the secondary layer is selected from one of UV curing acrylates, thermal curing epoxies, and sol-gel materials.

In some embodiments, a thickness of the secondary layer ranges from 10 to 50 microns.

In some embodiments, a refractive index of the texture supported on the second surface of the base layer is 1.5 and a refractive index of the secondary layer is greater or lesser than 1.5.

In some embodiments, a refractive index of the texture supported on the second surface of the base layer is 1.5 and a refractive index of said secondary layer is 1.7.

In some embodiments, the secondary layer comprises scattering particles.

### DESCRIPTION OF THE EXEMPLARY EMBODIMENTS

Before describing the present invention in detail, it should be observed that the present invention utilizes a combination of method steps and apparatus components related to a substrate for use in an optoelectronic device. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

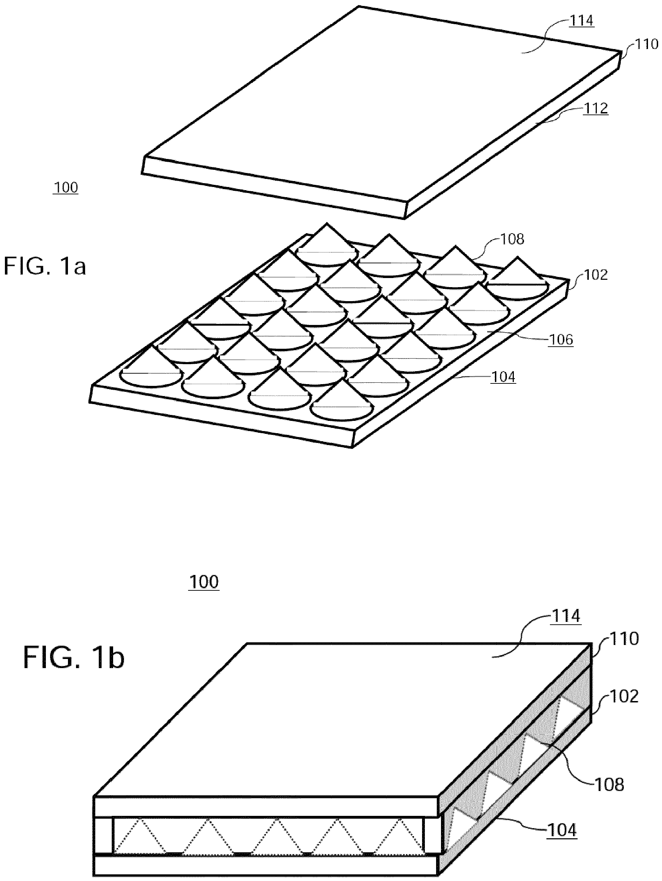

Referring now to the drawings, there is shown in FIG. 1a, there is shown an exemplary substrate 100, in accordance with an embodiment of the present invention. The substrate 100 is shown to include a base layer 102 having a first surface 104 and a second surface 106 placed opposite to the first surface 104. The second surface 106 has a texture 108. Further, the substrate 100 also includes a secondary layer 110 having a bottom surface 112 and a top surface 114.

The substrate 100 is configured to be used in an optoelectronic device, for example an Organic Light Emitting Diode (OLED) or a Light Emitting Diode (LED) or a thin film photovoltaic device (TF-PV). The substrate 100 acts as an emissive surface in case the optoelectronic device is an OLED or as a receiving surface for incident light in case the optoelectronic device is a TF-PV device.

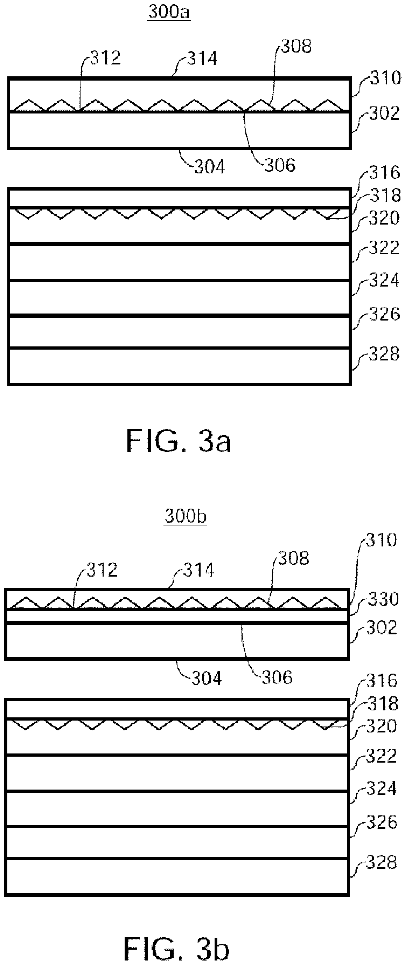

According to the invention, the base layer 102 of the substrate 100 functions to provide strength to the optoelectronic device. Examples of material useful as the base layer 102 of the transparent substrate include, but are not limited to, glass, flexible glass, polyethylene terephthalate (PET), polyethylene naphthalate (PEN), polycarbonate (PC) and other transparent or translucent material. The first surface 104 of the base layer 102 is configured to receive deposition thereon of one or more device components that enable functioning of the optoelectronic device. The one or more device components of the optoelectronic device include, but are not limited to, electrode layers and one or more organic layers. The one or more device components will be further described in conjunction with FIGs. 3a and 3b.

Moving on, the second surface 106 of the base layer 102 is configured to receive and support the texture 108. The texture 108 facilitates light management in the optoelectronic device. For example, when the optoelectronic device is an OLED, a light emitted by organic layers of the OLED, needs to pass through the substrate 100. However, when light is incident from a high refractive index material onto an interface with a lower refractive index material or medium, the light undergoes total internal reflection (TIR) for all incidence angles greater than the critical angle θ_{c}, defined by θ_{c} = sin⁻¹ (n₂/n₁), where n₁ and n₂ are the refractive indices of the high refractive index material and low refractive index material, respectively. Due to the same reason, when the light emitted by the one or more organic layers reaches an interface between the substrate 100 and an ambient medium, a substantial amount of light is reflected back into the OLED.

This can be prevented by presence of the texture 108, as the texture 108 is capable of changing propagation direction of the light at the interface between the substrate 100 and the ambient medium. The texture 108 helps reducing the TIR of the light back into the OLED. The texture 108 may include geometries having dimensions in the order of the wavelength of the light to facilitate the change in propagation direction of the emitted light by diffraction. The texture 108 may also include geometries having larger dimensions than the wavelength of the light to facilitate the change in propagation direction of the emitted light by refraction.

The texture 108 can bring about a change in the light propagation direction by either diffraction or refraction. Usually, the texture 108 having dimensions in the order of a wavelength of the light, change the light propagation direction by diffraction. Examples of the texture 108 that change the light propagation direction by diffraction include, but are not limited to, a 1D grating and a 2D grating. The texture 108 having dimensions larger than a wavelength of the light, usually change the light propagation direction by refraction. Examples of the texture 108 that change the light propagation direction by refraction include, but are not limited to, a lens, a cone, and a pyramid. Preferably, the texture 108 brings about a change in the light propagation direction by refraction and the dimension of the texture 108 is in the range of 5 to 50 microns.

In an embodiment, a stamper having an impression of the texture 108 can be pressed into the second surface 106 imprinting the texture 108 on the second surface 106, while the base layer 102 is being heated above its deformation (glass transition) temperature. This step can be followed by a rapid cooling process to affix the texture 108 on the second surface 106 as shown in FIG. 1a.

In yet another embodiment, a layer of a curable material, such as a photo-polymer lacquer or a sol-gel material is applied onto the second surface 106 to form a lacquer layer and the texture 108 is formed by imprinting or replicating impressions of the texture 108 into the lacquer layer. In this embodiment, the base layer 102 includes a first layer having the first surface 104 and the second surface 108 and also includes a lacquer layer on the second surface 106 of the first layer.

For example, the layer of the curable lacquer material can be applied onto the second surface 106. Thereafter, a stamper can be contacted with the layer of curable lacquer, imprinting the texture 108 to the lacquer layer. This can be followed by a curing process to affix the texture 108 to the curable lacquer on the second surface 106. Examples of the curable material can include, but is not limited to, an ultra-violet curable material, a photo-polymer lacquer, an acrylate, and silica or silica-titania based sol-gel materials. However, it should be understood that the curable lacquer can be formed of any material having similar characteristics without deviating from the scope of the invention. In an embodiment, a refractive index of a material forming the texture 108 is 1.5. For example, if the texture is formed on the lacquer layer, then the material of the lacquer is so chosen that its refractive index is 1.5.

Similarly, in case of a TF-PV device, the texture 108 can provide light trapping function. The texture 108 is provided is provided in the TF-PV device to increase an optical path of the light transmitted in to the TF-PV device. The texture 108 enables light extraction and light trapping in cases of an OLED and a TF-PV device respectively. The texture 108 is usually micron or submicron sized textures that are preferably one of periodic and quasi-periodic in nature. In an embodiment, the TF-PV device can be an organic photovoltaic device or an inorganic photovoltaic device.

Moving on to the secondary layer 110 of the substrate 100, the secondary layer 110 is defined by a bottom surface 112 and a top surface 114 opposite to the bottom surface 112. According to the invention, the secondary layer 110 is disposed on the base layer 102 (as shown in FIG. 1b) such that the bottom surface 112 substantially mates with the texture 108 on the second surface 106. Further, the top surface 114 is designed to be substantially flat and acts as an interface between the optoelectronic device and the ambient medium.

According to the invention, primary function of the secondary layer 110 is to cover and protect the texture 108 present on the second surface 106 from undergoing deformation or fouling due to exposure to the ambient medium. Examples of material for use as the secondary layer 110 include UV curing acrylates, thermal curing epoxies, sol-gel materials, hard-coats, and airogels. Further, the material used as the secondary layer 110 is highly transparent and exhibit low light absorption. Further, the secondary layer 110 is designed such that the interface between the optoelectronic device and the ambient medium is substantially flat as compared to the prior art where the interface included a texture for light management and was undulating in nature. In an embodiment, the second surface 110 fills any gaps formed in the texture 108. In an embodiment, a thickness of the secondary layer 110 is in the order of the dimensions of the texture 108. Preferably, the thickness of the secondary layer ranges from 10 to 50 microns. The secondary layer may have a refractive index gradient, or consist of more than one layer, each having different refractive indices.

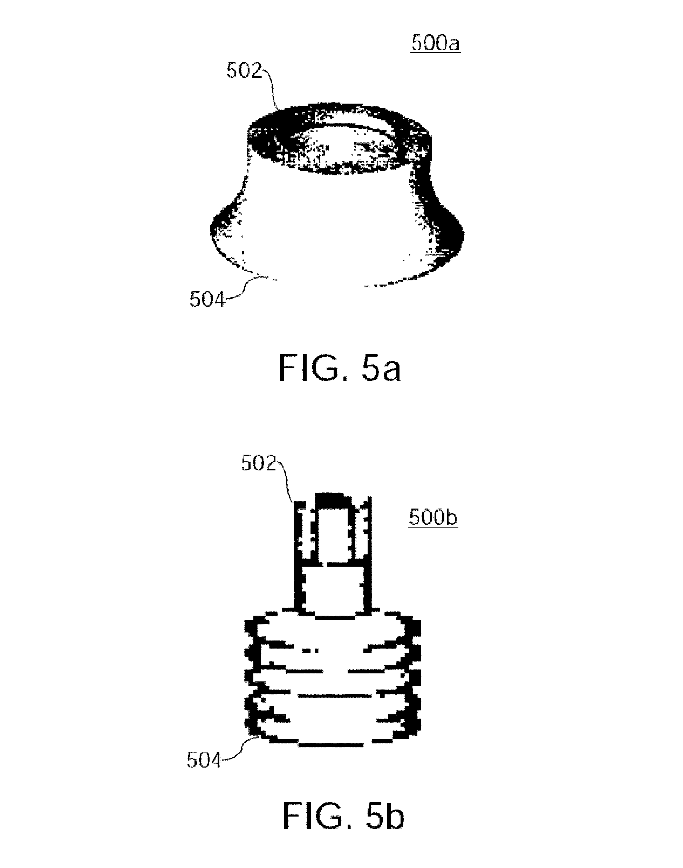

The secondary layer 110 not only functions to provide protection to the texture 108 from the ambient medium but also allows vacuum-based handling of the substrate 100 by providing a flat top surface 114. Presence of the flat top surface 114 allows easy handling of the substrate 100 by various mechanical devices used during manufacture of the optoelectronic device. For example, during manufacture of the optoelectronic device, the substrate needs to be moved or picked or rotated for various steps like cleaning, deposition of an electrode layers, deposition of organic layers and even encapsulation of the optoelectronic device. These movements are usually brought about by use of the mechanical devices like a vacuum gripper and presence of the flat top surface 114 allows easier handling and gripping than an undulating surface that existed in the prior art. For example, when a mating side of a vacuum gripper, for example, the side 504 of the exemplary vacuum grippers 500a and 500b shown in FIGs. 5a and 5b are contacted to a texture 108, then the gaps within the texture allow some air to pass when a suctions side 502 of the exemplary vacuum grippers 500a and 500b initiates suction to generate vacuum. Accordingly, based on the texture 108, the vacuum gripper may or may not be able to pick the optoelectronic device, for example, OLEDs. This reduces the reliability of handling the optoelectronic devices by vacuum grippers. When the secondary layer 110 is applied on the texture, in accordance with the present invention, the flat top surface 114 of the secondary layer facilitates substantially reliable handling by vacuum grippers.

In another embodiment, the secondary layer 110 further includes scattering particles. The presence of scattering particles adds to light management features provided by the texture 108. Also, any angular colour shift problems are reduced because of the presence of the scattering particles. Scattering using the scattering particles may be obtained by using a secondary layer that has a refractive index gradient, or consists of more than one layer, each having different refractive indices. Alternatively, a secondary layer with TiO₂ or ZrO2 particles, or similar, may be used. Also a secondary layer with voids or air or vacuum can be used for obtaining scattering.

Further, a refractive index value of a material chosen for the secondary layer 110 is important in terms of emission of the light. In an embodiment, the refractive index of the material forming the secondary layer 110 could have any value other than a refractive index of the texture 108. In case the refractive index of the secondary layer 110 is equal to the refractive index of the texture 108, then the change in the light propagation direction being provided by the texture 108 will be nullified resulting in a loss of efficiency. Therefore, preferably the refractive index of the material forming the secondary layer 110 is greater than or lesser than the refractive index of the texture 108 but not equal to the refractive index of the texture 108. For example, the refractive index of the secondary layer 110 can be 1.3 or lower. In another embodiment, the refractive index of the secondary layer 110 can be 1.7 or higher. Preferably difference in the refractive index of the secondary layer 110 and the texture 108 is preferred to be as high as possible. A low refractive index (< 1.3) of the secondary layer 110 allows a reduction in Fresnel reflections and serves as an anti-reflection coating. Similarly, a high refractive index (> 1.7) of the secondary layer 110 provides better light extraction efficiency, because there will be no TIR when passing from the texture 108 to the secondary layer 110. In an embodiment, the refractive index of the secondary layer 110 is 1.7. The refractive index of the secondary layer 110 is chosen such that there is no loss of light extraction efficiency in the optoelectronic device because of presence of the secondary layer 110.

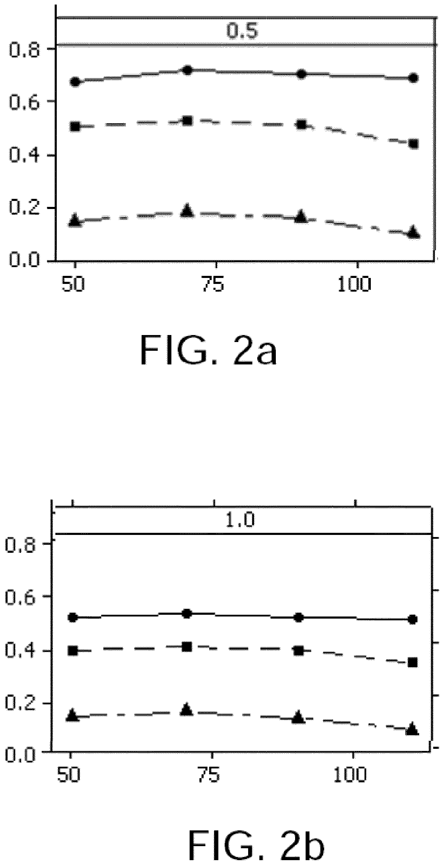

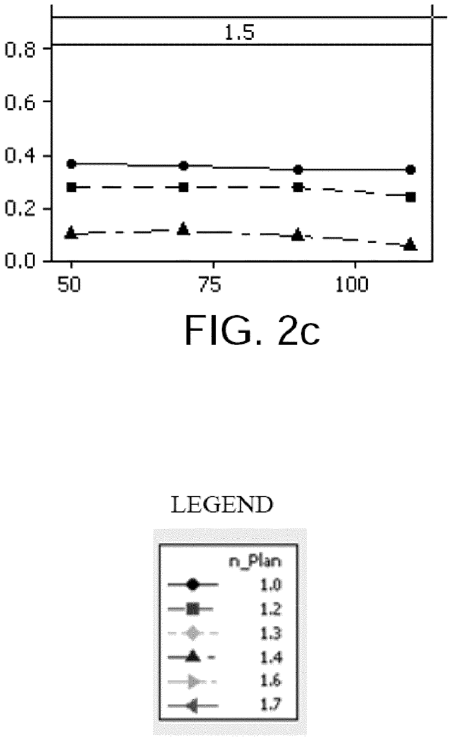

A graphical representation of experimental simulations carried out with various substrates to identify preferred refractive indices of the secondary layer, in accordance with an embodiment of the present invention, has been illustrated in FIGs. 2a, 2b and 2c. FIGs. 2a, 2b and 2c illustrate three graphs, each for a different 'cosine exponent'.

The graphs have been drawn with x-axis representing light gain and y-axis representing apex angles of the texture being used, in this case the texture being used are pyramid shaped in structure. The simulation is done by varying the texture, such that the pyramids being used as the texture have different top angles (apex angles). Further, the legend shows an indication of refractive index 'n_plan' of the secondary layer in the graph.

The cosine exponent in FIG. 2a is 0.5, in FIG. 2b is 1.0 and in FIG. 2c is 1.5. The cosine exponent is a parameter that is used to describe an angular directionality of light in the substrate. Light emission in an OLED usually obeys the formula I = cos n(α), wherein I = relative light intensity; α = incident angle of the light relative to the normal of a surface on which the light is incident and n = the cosine exponent. For example, a higher value denotes a more forward directed profile whereas a lower value represents a more sideward directed beam and when the cosine exponent is 1 then it corresponds to a Lambertian profile. Usually, lower the cosine exponent, more light will be trapped in the substrate, thus more light gain can be achieved.

Moving on, the light gain in the figures has been defined as (light output of an OLED with the texture) / (light output of an OLED without the texture) - 1.

As can be seen from the graph, smaller the refractive index 'n_plan', better the light extraction. Hence, preferably, material for the secondary layer is chosen such that the refractive index of the secondary layer is either greater than 1.7, yet more preferably greater than 1.8, or lesser than 1.3, or yet more preferably lesser than 1.2.

Referring now to FIG. 3a, there is shown a stack of layers in an exemplary OLED 300a in accordance with an embodiment of the present invention. For the purpose of the description, the OLED 300a has been shown to include only those layers that are pertinent to the description of the invention. However, it should be understood that the invention is not limited to the layers listed in the description here. In some cases, the OLED 300a may include additional layers to enhance efficiency or to improve reliability, without deviating from the scope of the invention.

Some real life examples of the OLED 300a can include, but are not limited to, Organic Light Emitting Diode (OLED), White Organic Light Emitting Diode (W-OLED), Active-matrix Organic Light Emitting Diodes (AMOLED), Passive-matrix Organic Light Emitting Diodes (PMOLED), Flexible Organic Light Emitting Diodes (FOLED), Stacked Organic Light Emitting Diodes (SOLED), Tandem Organic Light Emitting Diode, Transparent Organic Light Emitting Diodes (TOLED), Top Emitting Organic Light Emitting Diode, Bottom Emitting Organic Light Emitting Diode, Fluorescence doped Organic Light Emitting Diode (F-OLED) and Phosphorescent Organic Light Emitting Diode (PHOLED).

The OLED 300a is shown to include a base layer 302 of a substrate, a first surface 304, a second surface 306, a texture 308 for light extraction, a secondary layer 310 of the substrate, a bottom surface 312 a top surface 314. Also, the first surface 304 is configured to have one or more device components deposited thereon. The one or more device components include a lacquer layer 316, an internal light extraction texture 318, a first electrical contact 320, one or more organic layers 322 and 324, a second electrical contact 326 and a cover substrate 328.

The base layer 302, the first surface 304, the second surface 306, the texture 308, the secondary layer 310, the bottom surface 312 and the top surface 314 shown in the figure are similar in characteristics to the base layer 102, the first surface 104, the second surface 106, the texture 108, the secondary layer 110, the bottom surface 112 and the top surface 114 described in conjunction with FIGs. 1a and 1b,

In the OLED 300a, the first electrical contact 320 and the second electrical contact 326 are used to apply a voltage across the one or more organic layers 322 and 324. The first electrical contact 320 can be implemented with a transparent conductive layer (TCL), for example, a transparent conductive oxide (TCO), PEDOT-PSS, any other transparent polymers, or thin metal layers. TCOs are doped metal oxides, examples of TCOs include, but are not limited to, Aluminum-doped Zinc Oxide (AZO), Indium Zinc Oxide (IZO), Boron doped Zinc Oxide (BZO), Gallium doped Zinc Oxide (GZO), Fluorine doped Tin Oxide (FTO) and Indium doped Tin Oxide (ITO). Further, the second electrical contact 326 can be implemented with metals with appropriate work function to make injection of charge carriers, for example, calcium, aluminum, gold, and silver. In an embodiment, the first electrical contact 320 and the second electrical contact 326 act as electrode layers. For example the first electrical contact 320 acts as an anode and the second electrical contact 326 acts as a cathode.

The one or more organic layers 322 and 326 can be implemented with any organic electroluminescent material such as a light-emitting polymer, evaporated small molecule materials, light-emitting dendrimers or molecularly doped polymers.

In the OLED 300a light emitted by the one or more organic layers 322 and 324 needs to pass through the substrate. However, light incident from a high refractive index material, like the one or more organic layers 322 and 324 onto an interface with a lower refractive index material like the substrate, undergoes total internal reflection (TIR) for all incidence angles greater than the critical angle θ_{c}, defined by θ_{c} = sin⁻¹ (n₂/n₁), where n₁ and n₂ are the refractive indices of the high refractive index material and low refractive index material, respectively. Therefore, when the light emitted by the one or more organic layers 322 and 324 reaches their interface with the base layer 302 of the substrate, a substantial amount of light is reflected back into the one or more organic layers 322 and 324.

Therefore, just like the texture 108 described in conjunction with FIGs. 1a and 1b, presence of another texture, for example the internal light extraction texture 318 can help to reduce the reflection (or TIR) of the light back into the OLED 300a. The internal light extraction texture 318 is similar in function to the texture 308 and the texture 108.

Usually, the internal light extraction texture 318 is formed on a layer of a curable material, such as a photo-polymer lacquer or a sol-gel material. In an embodiment, the layer of the curable material is applied onto the first surface 304 to form the lacquer layer 316 and the internal light extraction texture 318 is formed by imprinting or replicating impressions of the internal light extraction texture 318 onto the lacquer layer 316. Examples of material used as the lacquer layer 316 include, but is not limited to, an ultra-violet curable material, a photo-polymer lacquer, an acrylate, and silica or silica-titania based sol-gel materials.

Another embodiment, of an OLED 300b in accordance with another embodiment of the present invention has been shown in FIG. 3b. In the embodiment the texture 308 is formed on a lacquer layer 330 instead of being directly formed on the second surface 306.

It should be understood that for the purpose of description, the optoelectronic device has been explained in reference to an OLED and light extraction, however, it will be readily apparent to those ordinarily skilled in the art that the present invention can be implemented in a TF-PV device as well for light management purposes, like, light trapping.

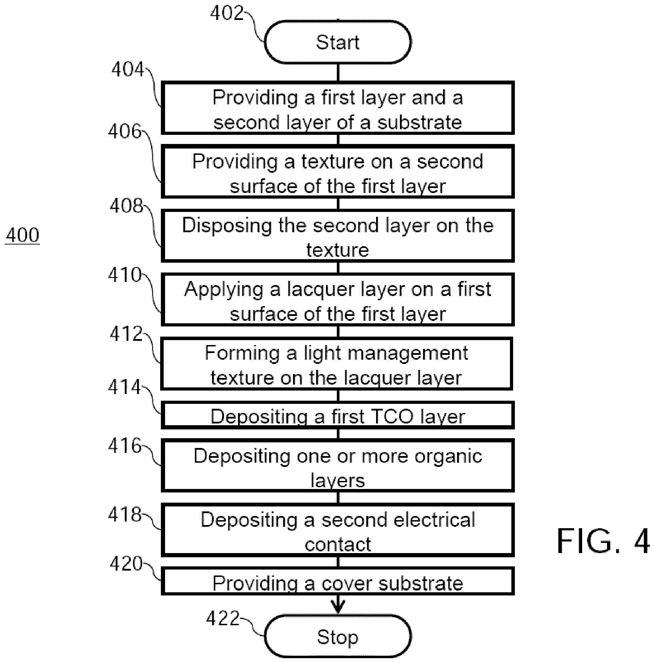

Moving on to FIG. 4, there is shown a flowchart depicting a method 400 of manufacturing an optoelectronic device, for example the OLED 300a, in accordance with an embodiment of the present invention. To describe the method 400, reference will be made to FIGs. 1, 2 and 3, although it is understood that the method 400 can be implemented to manufacture any other suitable device. Moreover, the invention is not limited to the order of in which the steps are listed in the method 400. In addition, the method 400 can contain a greater or fewer numbers of steps than those shown in FIG. 4.

Further, for the purpose of description, the method 400 has been explained in reference to an OLED and light extraction, however, it will be readily apparent to those ordinarily skilled in the art that the present invention can be implemented in a TF-PV device as well for light management purposes, like, light trapping.

The method 400 is initiated at step 402. At step 404, a base layer and a secondary layer, for example the base layer 302 and the secondary layer 310 are provided.

Thereafter, at step 406, a texture, for example the texture 308 is formed on the second surface 306 of the base layer 302. Usually, a stamper having an impression of the texture 308 can be pressed into the second surface 306 imprinting the texture 308 on the second surface 306, while the base layer 302 is being heated above its deformation (glass transition) temperature. This step can be followed by a rapid cooling process to affix the texture 308 on the second surface 306.

However, in another embodiment, a layer of a curable material, such as a photo-polymer lacquer or a sol-gel material is applied onto the second surface 306 and the texture 308 is formed by imprinting or replicating impressions of the texture 308 onto the lacquer layer. For example, a curable lacquer, such as a photo-polymer lacquer or a sol-gel material can be applied onto the second surface 306. Thereafter, a stamper can be contacted with the curable lacquer, imprinting the texture 308 to the curable lacquer. This can be followed by a curing process to affix the texture 308 to the lacquer layer on the second surface 306.

Thereafter, at step 408, the secondary layer 310 is disposed on the texture 308, such that the bottom surface 312 of the secondary layer 310 substantially mates with the texture 308. In an embodiment, the secondary layer 310 can be applied by using a brush or roller, dispensing, slot dye coating, spin-coating, spray coating, dip coating, screen printing and ink jet printing or laminating a foil.

Thereafter, step 410 onwards, one or more device components of the OLED 300a are deposited on the first surface 304 of the base layer 302. At step 410, a lacquer material is applied on the first surface 304 to form a lacquer layer 316. Examples of the lacquer material can include, but is not limited to, an ultra-violet curable material, a photo-polymer lacquer, an acrylate, and silica or silica-titania based sol-gel materials. However, it should be understood that the lacquer layer can be formed of any material having similar characteristics without deviating from the scope of the invention. Further, the lacquer material can be deposited by using a brush or roller, dispensing, slot dye coating, spin-coating, spray coating, or printing.

Thereafter, at step 412, an internal light management texture, for example the internal light extraction texture 318, is formed on the lacquer layer 316. In an embodiment, a transfer stamper is used to imprint or replicate impressions of the internal light extraction texture 318 onto the lacquer layer 316.

Subsequently, at step 414, a TCO layer, for example the first electrical contact 320 is deposited with conventional known methods on the internal light extraction texture 318. The first electrical contact 320 can be deposited by using various methods, such as dip coating, spin coating, doctored blade, spray coating, screen printing, sputtering, glass mastering, photoresist mastering, electroforming, and evaporation. In an embodiment, the first electrical contact 320 acts as an anode.

Thereafter, at step 416, one or more organic layers, for example the one or more organic layers 322 and 324 are deposited on the first electrical contact 320. The one or more organic layers 322 and 324 can be deposited by using various methods, such as dip coating, spin coating, doctored blade, spray coating, screen printing, sputtering, glass mastering, photoresist mastering, all kinds of CVD, electroforming, and evaporation.

Thereafter, at steps 418 and 420 a second electrical contact and a cover substrate are applied using conventional methods. Following which the method 400 is terminated at step 422.

During the method 400, the optoelectronic device, for example, the OLED 300a, or in-process versions thereof are picked up and handles using vacuum grippers. The present invention facilitates reliable handling at such instances.

Various embodiments, as described above, provide a substrate for use in an optoelectronic device that has several advantages. The substrate according to the invention includes two layers, such that a secondary layer of the substrate is provided to cover a texture on provided at an interface between the base layer and the ambient medium. In case the secondary layer is not present, the texture creates problems during manufacturing of the optoelectronic device. For example, during various stages of the manufacturing process, the substrate having the texture at the interface with the ambient medium needs to be picked up or moved or rotated using mechanical devices. These movements often result in deformation of the texture. Also, the mechanical devices, for example vacuum grippers, used for enabling these movements find it difficult to handle and grip the substrates having the texture as vacuum cannot be built up properly. These problems have been countered in the present invention by providing the secondary layer which has a flat external surface that allows easy gripping and handling compared to the prior art. Additionally, the refractive index of the secondary layer is so chosen that there is no loss of efficiency in the optoelectronic device.

While the invention has been disclosed in connection with the preferred embodiments shown and described in detail, various modifications and improvements thereon will become readily apparent to those ordinarily skilled in the art. Accordingly, the spirit and scope of the present invention is not to be limited by the foregoing examples, but is to be understood in the broadest sense allowable by law.

All documents referenced herein are hereby incorporated by reference.

## Claims

1. A substrate (100) for use in an optoelectronic device (300a, 300b), said substrate (100) comprising:
a base layer (102, 302) having a first surface (104, 304) and a second surface (106, 306), said first surface (104, 306) having one or more device components (316 - 328) of said optoelectronic device (300a, 300b) deposited thereon,
wherein said second surface (106, 306) has a texture (108, 308) thereon to facilitate light management in said optoelectronic device (300a, 300b);
**characterized in that**
a secondary layer (110, 310) being disposed over said texture (108, 308) such that a top surface (114, 314) of said secondary layer (110, 310) is substantially flat, whereby an interface between said optoelectronic device (300a, 300b) and an ambient medium is substantially flat, and further whereby said secondary layer (110, 310) enabling at least one of protection of said texture (108, 308) from said ambient medium and vacuum-based handling of said substrate (100).

2. The substrate (100) according to claim 1, wherein said texture (108, 308) is imprinted on said second surface (106, 306) of said base layer (102, 302) of said substrate (100).

3. The substrate (100) according to claim 1 or 2, wherein said base layer (102, 302) comprising:
a first layer (302) having a first surface (304) and a second surface (306), said first surface (304) having one or more device components (316 - 328) of said optoelectronic device (300a, 300b) deposited thereon; and
a lacquer layer (330) deposited on said second surface (306) of said first layer (302), said texture (308) being formed on said lacquer layer (330).

4. The substrate (100) according to one of claims 1 to 3, wherein said light management facilitated by said texture (108, 308) is light extraction when said optoelectronic device (300a, 300b) is one of an Organic Light Emitting Diode (OLED) and a Light Emitting Diode (LED).

5. The substrate (100) according to one of claims 1 to 4, wherein said light management facilitated by said texture (108, 308) is light trapping when said optoelectronic device (300a, 300b) is a Thin Film Photovoltaic Device (TF-PV).

6. The substrate (100) according to one of claims 1 to 5, wherein a material of said secondary layer (110, 310) is selected from one of UV curing acrylates, thermal curing epoxies, and sol-gel materials.

7. The substrate (100) according to one of claims 1 to 6, wherein a thickness of said secondary layer (110, 310) ranges from 10 to 50 microns.

8. The substrate (100) according to one of claims 1 to 7, wherein a refractive index of said texture (108, 308) supported on said second surface (106, 306) of said base layer (102, 302) is 1.5 and a refractive index of said secondary layer (110, 310) is greater or lesser than 1.5.

9. The substrate (100) according to one of claims 1 to 8, wherein a refractive index of said texture (108, 308) supported on said second surface (106, 306) of said base layer (102, 302) is 1.5 and a refractive index of said secondary layer (110, 310) is 1.7.

10. The substrate according to one of claims 1 to 9, wherein said secondary layer (110, 310) comprises scattering particles.
